(19) Europäisches Patentamt / European Patent Office / Office européen des brevets

(11) **EP 2 337 043 B1**

(12) **EUROPEAN PATENT SPECIFICATION**

(45) Date of publication and mention
of the grant of the patent:
**30.03.2016 Bulletin 2016/13**

(51) Int Cl.:
*H01H 1/00* *(2006.01)*    *H01H 9/54* *(2006.01)*
*H01H 59/00* *(2006.01)*    *H01H 71/00* *(2006.01)*

(21) Application number: **10194449.4**

(22) Date of filing: **10.12.2010**

(54) **Switch structure and associated circuit**

Schaltstruktur und zugehörige Schaltung

Structure de commutation et circuit associé

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.12.2009 US 639060**

(43) Date of publication of application:
**22.06.2011 Bulletin 2011/25**

(73) Proprietor: **General Electric Company
Schenectady, NY 12345 (US)**

(72) Inventors:
• **Gowda, Arun Virupaksha
Niskayuna, NY 12309 (US)**
• **O'Brien, Kathleen Ann
Niskayuna, NY 12309 (US)**
• **Park, John Norton
Rexford, NY 12148 (US)**
• **Premerlani, William James
Scotia, NY 12302 (US)**
• **Schelenz, Owen Jannis Samuel
Niskayuna, NY 12309 (US)**
• **Subramanian, Kanakasabapathi
Niskayuna, NY 12309 (US)**

(74) Representative: **Illingworth-Law, William
Illingworth
GPO Europe
GE International Inc.
The Ark
201 Talgarth Road
Hammersmith
London W6 8BJ (GB)**

(56) References cited:
**EP-A2- 2 045 823    EP-A2- 2 056 325
FR-A1- 2 797 359    US-A- 5 616 972**

EP 2 337 043 B1

**Description**

BACKGROUND

Embodiments of the invention relate generally to devices for switching current, and more particularly to microelectromechanical switch structures.

A circuit breaker is an electrical device designed to protect electrical equipment from damage caused by faults in the circuit. Traditionally, many conventional circuit breakers include bulky (macro-)electromechanical switches. Unfortunately, these conventional circuit breakers are large in size may necessitate use of a large force to activate the switching mechanism. Additionally, the switches of these circuit breakers generally operate at relatively slow speeds. Furthermore, these circuit breakers can be complex to build and thus expensive to fabricate. In addition, when contacts of the switching mechanism in conventional circuit breakers are physically separated, an arc can sometimes form therebetween, which arc allows current to continue to flow through the switch until the current in the circuit ceases. Moreover, energy associated with the arc may seriously damage the contacts and/or present a burn hazard to personnel.

As an alternative to slow electromechanical switches, relatively fast solid-state switches have been employed in high speed switching applications. These solid-state switches switch between a conducting state and a non-conducting state through controlled application of a voltage or bias. However, since solid-state switches do not create a physical gap between contacts when they are switched into a non-conducting state, they experience leakage current when nominally non-conducting. Furthermore, solid-state switches operating in a conducting state experience a voltage drop due to internal resistances. Both the voltage drop and leakage current contribute to power dissipation and the generation of excess heat under normal operating circumstances, which may be detrimental to switch performance and life. Moreover, due at least in part to the inherent leakage current associated with solid-state switches, their use in circuit breaker applications is not possible.

Micro-electromechanical system (MEMS) based switching devices may provide a useful alternative to the macro-electromechanical switches and solid-state switches described above for certain current switching applications. MEMS-based switches tend to have a low resistance when set to conduct current, and low (or no) leakage when set to interrupt the flow of current therethrough. Further, MEMS-based switches are expected to exhibit faster response times than macro-electromechanical switches. An example of a system with a MEMS based switch can be found in EP 2045823.

BRIEF DESCRIPTION

The present invention provides an apparatus as defined in claim 1.

In one aspect, an apparatus, such as a switch module, is provided. The apparatus can include an electromechanical switch structure configured to move between an open configuration and a fully-closed configuration over a characteristic time (*e.g.*, less than or equal to about 15 microseconds). When in the fully-closed configuration, the electromechanical switch structure can have a minimum characteristic resistance.

The electromechanical switch structure can include one or more contacts and one or more moveable elements, with each of the moveable elements being in maximum contact with at least one of the contacts when the electromechanical switch structure is disposed in the fully-closed configuration and each of the moveable elements being separated from the contacts when the electromechanical switch structure is disposed in the open configuration. The electromechanical switch structure can include, for example, a microelectromechanical switch. The electromechanical switch structure can also include an electrode configured to selectively receive a charge so as to establish a potential difference with the moveable element and thereby urge the moveable element over the characteristic time between a maximum contacting position, in which said moveable element makes maximum contact with the contact, and a non-contacting position, in which said moveable element is separated from the contact.

The electromechanical switch structure can include an array of electromechanical switches having a minimum characteristic effective array resistance when in the fully-closed configuration. The array can include at least two electromechanical switches connected in parallel and/or at least two electromechanical switches connected in series.

A commutation circuit can be connected in parallel with the electromechanical switch structure. The commutation circuit can include a balanced diode bridge configured to suppress arc formation between contacts of the electromechanical switch structure. The commutation circuit can also include a pulse circuit including a pulse capacitor configured to form a pulse signal for causing flow of a pulse current through the balanced diode bridge. The pulse signal can be generated in connection with a switching event of the electromechanical switch structure. The electromechanical switch structure and the balanced diode bridge can be disposed such that a total inductance associated with the commutation circuit is less than or equal to a product of the characteristic time and the minimum characteristic resistance.

In some embodiments, a second electromechanical switch structure can be included, the second electromechanical switch structure being configured to move between an open configuration and a fully-closed configuration over a second characteristic time. The second electromechanical switch structure can have a second minimum characteristic resistance when in the fully closed configuration. The (first) electromechanical switch structure can then be associated with a first characteristic time and a first minimum characteristic resistance. The first and second electromechanical switch structures can be configured to connect in parallel to a load circuit, with the commutation circuit connected in parallel with each of the first and second electromechanical switch structures. A first balanced diode bridge can be configured to suppress arc formation between contacts of the first electromechanical switch structure, and a second balanced diode bridge can be configured to suppress arc formation between contacts of the second electromechanical switch structure. The pulse circuit can include a pulse capacitor configured to form a pulse signal for causing flow of a pulse current through each of the first and second balanced diode bridges, the pulse signal being generated in connection with a switching event of the first and second electromechanical switch structures. The first and second electromechanical switch structures and the first and second balanced diode bridges can be disposed such that a total inductance associated with the pulse circuit and the first balanced diode bridge is less than or equal to a product of the first characteristic time and the first minimum characteristic resistance, while a total inductance associated with the pulse circuit and the second balanced diode bridge is less than or equal to a product of the second characteristic time and the second minimum characteristic resistance.

In another aspect, an apparatus, such as a switch module, is provided. The apparatus can include a first electromechanical switch structure configured to move between a fully-open configuration and a fully-closed configuration over a first characteristic time, and a second electromechanical switch structure configured to move between a fully-open configuration and a fully-closed configuration over a second characteristic time. The first electromechanical switch structure can have a first minimum characteristic resistance when in the fully closed configuration, and the second electromechanical switch structure can have a second minimum characteristic resistance when in the fully closed configuration. The second electromechanical switch structure can be configured to connect to a load circuit in parallel or in series with the first electromechanical structure.

A first commutation circuit can be connected in parallel with the first electromechanical switch structure. The first commutation circuit can include a first balanced diode bridge and a first pulse circuit. The first balanced diode bridge can be configured to suppress arc formation between contacts of the first electromechanical switch structure. The first pulse circuit can include a pulse capacitor configured to form a pulse signal for causing flow of a pulse current through the first balanced diode bridge, the pulse signal being generated in connection with a switching event of the first electromechanical switch structure.

A second commutation circuit can be connected in parallel with the second electromechanical switch structure. The second commutation circuit can include a second balanced diode bridge and a second pulse circuit. The second balanced diode bridge can be configured to suppress arc formation between contacts of the second electromechanical switch structure. The second pulse circuit can include a pulse capacitor configured to form a pulse signal for causing flow of a pulse current through the second balanced diode bridge, the pulse signal being generated in connection with a switching event of the second electromechanical switch structure.

The first electromechanical switch structure and the first balanced diode bridge can be disposed such that a total inductance associated with the first commutation circuit is less than or equal to a product of the first characteristic time and the first minimum characteristic resistance. The second electromechanical switch structure and the second balanced diode bridge can also be disposed such that a total inductance associated with the second commutation circuit is less than or equal to a product of the second characteristic time and the second minimum characteristic resistance.

In yet another aspect, a method is disclosed, the method including providing an apparatus including an electromechanical switch structure and a commutation circuit connected in parallel with the electromechanical switch structure. The electromechanical switch structure can be configured to move between an open configuration and a fully-closed configuration, having a minimum characteristic resistance when in the fully-closed configuration. The commutation circuit can include a balanced diode bridge configured to suppress arc formation between contacts of the electromechanical switch structure. A pulse circuit including a pulse capacitor can be configured to form a pulse signal for causing flow of a pulse current through the balanced diode bridge, the pulse signal being generated in connection with a switching event of the electromechanical switch structure. An electrostatic force can be applied to move the electromechanical switch structure into the fully-closed configuration. The electrostatic force can be varied so as to move the electromechanical switch structure over a characteristic time from the fully-closed configuration to the open configuration, wherein the characteristic time is greater than a total inductance associated with said commutation circuit divided by the minimum characteristic resistance.

DRAWINGS

These and other features, aspects, and advantages of the present invention will become better understood when the following detailed description is read with reference to the accompanying drawings in which like characters represent like parts throughout the drawings, wherein:

Fig. 1 is a schematic view of a switch module configured in accordance with an example embodiment;

Fig. 2 is a schematic perspective view of an example electromechanical switch;

Fig. 3 is a side view of the switch of Fig. 2;

Fig. 4 is a side view of the switch of Fig. 2 in a partially-closed configuration;

Fig. 5 is a side view of the switch of Fig. 2 in a fully-closed configuration;

Fig. 6 is a plot of switch resistance, gate voltage, and actuating force as a function of time for the switch of Fig. 2;

Figs. 7-10 are schematic views representing an example operation of the switch module of Fig. 1;

Figs. 11-15 are schematic views of respective switch module configured in accordance with other example embodiments; and

Fig. 16 is a schematic view of an equivalent circuit for the switch module of Fig. 1.

DETAILED DESCRIPTION

Example embodiments of the present invention are described below in detail with reference to the accompanying drawings, where the same reference numerals denote the same parts throughout the drawings. Some of these embodiments may address the above and other needs.

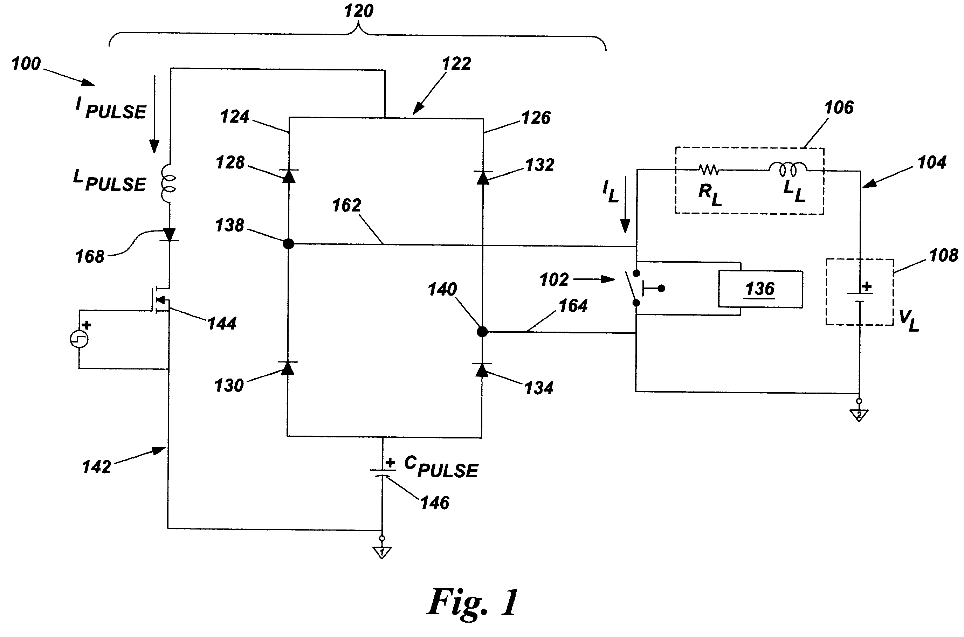

Referring to Fig. 1, therein is shown an apparatus, such as a switch module **100** (*e.g.,* for use in conjunction with motor starter applications), configured in accordance with an example embodiment. The switch module **100** can include an electromechanical switch structure, such as a microelectromechanical switch or a microelectromechanical system (MEMS) switch **102**. The MEMS switch **102** can be incorporated as part of a load circuit **104** that also includes, for example, an electrical load **106** characterized by a load inductance $L_L$ and a load resistance $R_L$. It is noted that the load circuit **104** may also include inherent inductance and resistance, and these will contribute to, and will be considered to be included in, the effective load inductance $L_L$ and a load resistance $R_L$. A power source **108** can also be included in the load circuit **104** so as to provide a voltage $V_L$. As discussed further below, during operation, a load circuit current $I_L$ may flow through the load circuit **104** and, in some cases, the MEMS switch **102.**

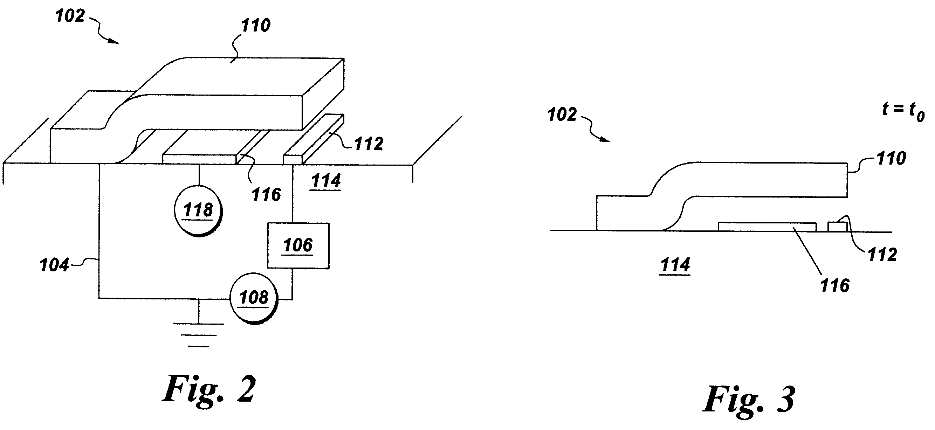

Referring to Figs. 1 and 2, the MEMS switch **102** can include contacts, such as a moveable element (*e.g.,* as a cantilevered beam **110)** and a contact **112**, (*e.g.,* a conductive pad). The beam **110** and contact **112** can be supported by an underlying support structure, such as a substrate **114**. Disposing the beam **110** and the contact **112** on a common substrate **114** may facilitate the production of the MEMS switch **102** through conventional microfabrication techniques (*e.g.,* electroplating, vapor deposition, photolithography, wet and/or dry etching, etc.), with the resulting switch having dimensions on the order of ones or tens of micrometers and/or nanometers.

It is noted that while the electromechanical switch structure referenced above was described in terms of a solitary switch **102** having a single moveable element, the electromechanical switch structure may include an array of electromechanical switches connected in parallel, in series, or both, where each switch of the array includes a moveable element that is associated with a common or individual contacts. As such, references throughout to "a switch" (*e.g.,* MEMS switch 102) should be understood to refer to either a single switch or a switch array.

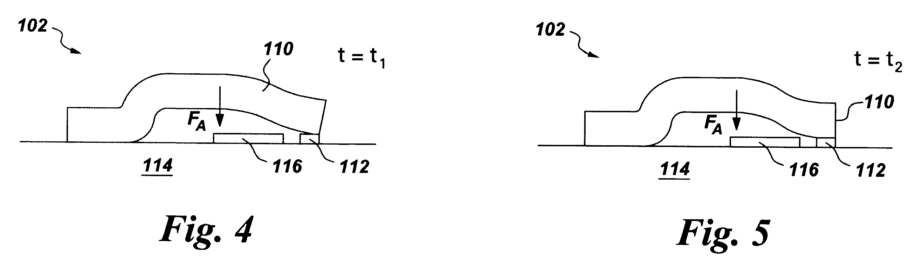

Referring to Figs. 1-6, the MEMS switch **102** can be configured to be selectively moveable between a non-contacting or "open" configuration or state, in which the beam **110** is separated from the contact **112** (*e.g.,* as depicted in Fig. 3), and a contacting or "fully-closed" configuration or state, in which the beam makes maximum contact and establishes electrical communication with the contact (*e.g.,* as depicted in Fig. 5). For example, the beam **110** can be configured to undergo deformation when moving between open and fully-closed configurations, such that the beam is naturally disposed *(i.e.,* in the absence of externally applied forces) in a non-contacting configuration and may be deformed so as to occupy a contacting position while storing mechanical energy therein. In other embodiments, the undeformed configuration of the beam **110** may be the contacting configuration.

The MEMS switch **102** may include an electrode **116,** which electrode may be in electrical communication with a gate voltage source **118**. The gate voltage source **118** may provide a gate voltage $V_G$ to the electrode, thereby supplying charge to the electrode. As the electrode **116** is charged, a potential difference is established between the electrode and the beam **110,** and an electrostatic actuating force $F_A$ can act to pull the beam towards the electrode (and also towards, and ultimately into contact with, the contact **112).**

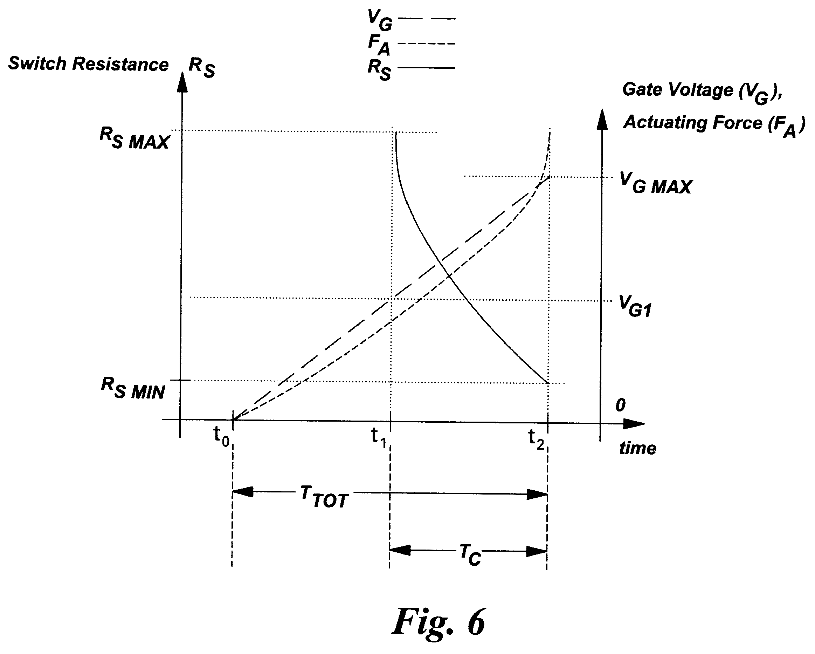

The gate voltage $V_G$ may vary from zero at a time $t_0$ to a value of $V_{G1}$ at a time $t_1$. The electrostatic actuating

force $F_A$ can vary (although not necessarily linearly) with the gate voltage $V_G$. As the gate voltage $V_G$ (and electrostatic actuating force $F_A$) increases, the actuating force causes the beam **110** to move toward the contact **112,** and eventually (at time $t_1$ in Fig. 6) the actuating force (corresponding to a gate voltage of $V_{G1}$ in Fig. 6) reaches a magnitude sufficient to cause the beam to deform so as to just allow electrical communication between the beam and the contact. This will nominally occur when the beam **110** contacts the contact **112,** but may actually occur before the beam and contact are in contact, as the separation between the two may be small enough to allow for electrical communication across any physical gap that may separate the beam and contact (*e.g.,* via field emission). In any event, at time $t_1$, the characteristic switch resistance $R_S$ (the effective resistance presented by the beam **110** and contact **112)** goes from essentially infinity (the value of $R_S$ in the time period from $t_0$ to $t_1$ when the beam is spaced apart from the contact) to some large but finite value $R_{SMAX}$. In embodiments where the electromechanical switch structure includes an array of electromechanical switches, it should be understood that the characteristic switch resistance is equivalent to the effective resistance of the switch array *(i.e.,* the resistance as would be found if the switch array were replaced by a single equivalent resistor).

The gate voltage $V_G$ may continue to increase to a maximum value of $V_{GMAX}$ at a time $t_2$. As the gate voltage $V_G$ increases, the actuation force $F_A$ will also increase, urging the beam **110** into more extensive contact with the contact **112.** Correspondingly, the characteristic switch resistance $R_S$ will decrease over the time from $t_1$ to $t_2$ from $R_{SMAX}$ to a minimum value of $R_{SMIN}$. The minimum value of the characteristic switch resistance $R_S$ for the switch **102** is indicative of the fully-closed configuration of the switch, with other configurations of the switch (*e.g.,* the configuration of Fig. 4, referred to as "partially closed" or, conversely, "partially open") being characterized by higher resistance values.

As mentioned above, when the switch **102** is in the fully-closed configuration, the beam **110** makes maximum contact with the contact **112.** It is noted that the term "maximum contact," in this case, refers to the greatest amount of contact that is actually made between the beam and contact, and not the greatest possible amount of contact between those two structures. It may often be true that the beam **110** and contact **112** can be brought into greater contact by increasing the gate voltage $V_G$ applied to the electrode **116.** In embodiments where the switch 102 includes an array of switches, the fully-closed configuration refers to the situation in which all of the switches in the array are closed to the maximum extent, while the partially-closed configuration is indicative of the situation in which at least one switch of the switch array is not fully-closed. For example, the switch array can include one or more contacts and one or more moveable elements, with each of the moveable elements being in maximum contact with at least one associated contact when the overall electromechanical switch structure is disposed in the fully-closed configuration and each of the moveable elements being separated from an associated contact when the electromechanical switch structure is disposed in the open configuration.

During a switching event *(i.e.,* a movement of the switch **102** from a non-conducting state to a conducting state or vice versa), the gate voltage $V_G$ may be varied over a switching event time $T_{TOT}$ that is equal to $t_2 - t_0$. However, the switch **102** may be configured to move from an open configuration (a configuration in which the beam **110** and the contact **112** are separated just enough to substantially preclude electrical communication therebetween) to the fully-closed configuration over a characteristic time $T_C$ that is equal to $t_2 - t_1$. For switching events in which the switch **102** is being opened, the gate voltage $V_G$ would be decreased instead of increased. In the case where the switch **102** includes a switch array, the characteristic time $T_C$ may refer to the time between when the first switch of the array just closes and when all of the switches of the array are closed to the maximum extent. In embodiments where the electromechanical switch structure includes an array of electromechanical switches, the "characteristic time" associated with the switch array is the time required to move from a configuration of the switches in which a minimum effective array resistance is realized to a configuration in which the effective array resistance is infinite (*e.g.,* for two switches in parallel, the longer of the opening times associated with each of the switches, for two switches in series, the shorter of the opening times).

Referring again to Fig. 1, a commutation circuit 120 can be connected in parallel with the switch **102.** The commutation circuit **120** can include a balanced diode bridge **122** having a first branch **124** and a second branch **126.** As used herein, the term "balanced diode bridge" is used to represent a diode bridge that is configured such that voltage drops across both the first and second branches **124, 126** are substantially equal. The first branch **124** of the balanced diode bridge **122** may include a first diode **128** and a second diode **130** coupled together in series circuit. In a similar fashion, the second branch **126** may include a third diode 132 and a fourth diode **134** operatively coupled together in series.

A voltage snubber circuit **136** may be coupled in parallel with the switch **102** and configured to limit voltage overshoot during fast contact separation. In certain embodiments, the snubber circuit **136** may include a snubber capacitor (not shown) coupled in series with a snubber resistor (not shown). The snubber capacitor may facilitate improvement in transient voltage sharing during the sequencing of the opening of the switch **102.** Furthermore, the snubber resistor may suppress any pulse of current generated by the snubber capacitor during closing operation of the switch **102.** In certain other embodiments, the voltage snubber circuit **136** may include a metal oxide varistor (MOV) (not shown).

The first MEMS switch **102** may be coupled in parallel across midpoints **138, 140** of the balanced diode bridge **122.** A first midpoint **138** may be located between the first and second diodes **128, 130,** and a second midpoint **140** may be located between the third and fourth diodes **132, 134.**

The commutation circuit **120** can also include a pulse circuit **142** coupled in operative association with the balanced diode bridge **122.** The pulse circuit **142** may be configured to detect a switch condition and initiate a switching event (an opening or closing of the switch **102** responsive to the switch condition. As used herein, the term "switch condition" refers to a condition that triggers changing a present operating state of the switch **102.** A switch condition may occur in response to a number of actions including but not limited to a circuit fault or switch ON/OFF request.

The pulse circuit **142** may include a pulse switch **144** and a pulse capacitor **146** coupled together in series, the pulse capacitor having a capacitance $C_{PULSE}$. The pulse circuit **142** may also include a first diode **148** coupled in series with the pulse switch **144,** and the pulse circuit may be characterized by a pulse inductance $L_{PULSE}$. The pulse capacitor **146** can be configured to form a pulse signal for inducing a pulse current $I_{PULSE}$ through the balanced diode bridge **122.** The pulse signal could be generated, for example, in connection with a switching event of the switch **102.** The pulse inductance $L_{PULSE}$, the diode **148,** the pulse switch **144,** and the pulse capacitor **146** may be coupled in series to form a first branch of the pulse circuit **142,** where the components of the first branch may be configured to facilitate pulse current shaping and timing.

Referring to Figs. 2 and 7-10, as discussed further below, in operation, the balanced diode bridge **122** can be configured to suppress arc formation between contacts (*e.g.,* the beam **110** and the contact **112)** of the switch **102.** In some embodiments, this may enable the MEMS switch **102** to be rapidly switched (*e.g.,* on the order of picoseconds or nanoseconds) from a closed state to an open state while carrying a current (albeit at a near-zero voltage).

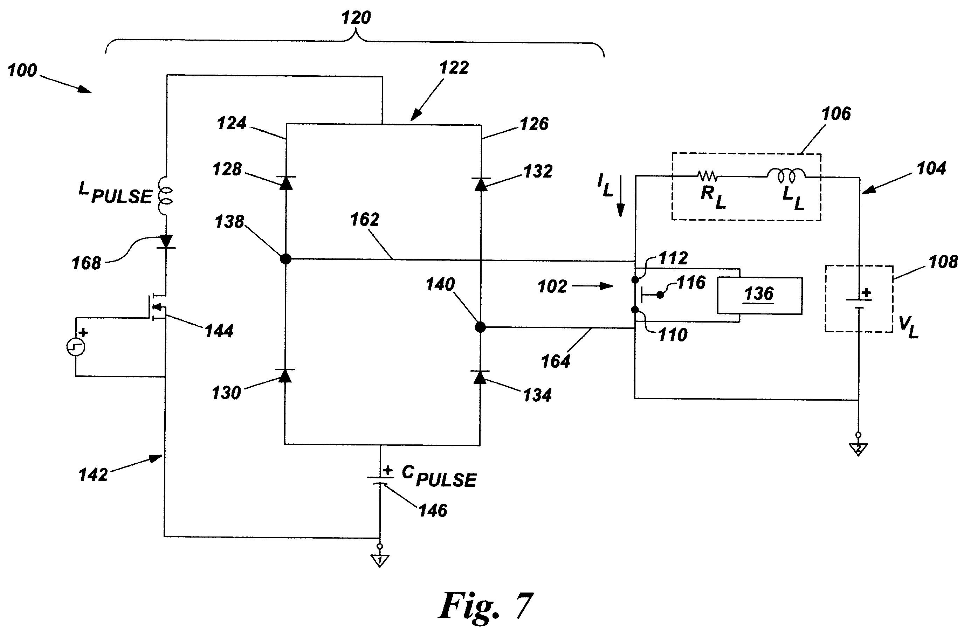

Figs. 7-10 are used as schematic flow charts to illustrate an example operation of the switch module **100.** An initial condition of the example operation of the switch module **100** is illustrated in Fig. 7. The switch **102** is depicted as starting in a fully-closed configuration, and a load current $I_L$, which has a value substantially equal to $V_L/R_L$, is present in the load circuit **104.**

Moreover, for discussion of this example operation, it may be assumed that the characteristic resistance $R_{SMIN}$ associated with the MEMS switch **102** in the fully-closed configuration is sufficiently small such that the voltage produced by the load current through the resistance of MEMS switch has only a negligible effect on the near-zero voltage difference between the mid-points **138, 140** of the diode bridge **122** when pulsed. For example, the characteristic resistance $R_{SMIN}$ associated with the fully-closed MEMS switch **102** may be assumed to be sufficiently small so as to produce a voltage drop of less than a few millivolts due to the maximum anticipated load current.

It may be noted that in this initial condition of the switch module **100,** the pulse switch **144** is in a first open state. Additionally, there is no current in the pulse circuit **142** (*i.e.,* $I_{PULSE}$ = 0). Also, in the pulse circuit **142,** the capacitor **146** may be pre-charged to a voltage $V_{PULSE}$, where $V_{PULSE}$ is a voltage that can produce a half sinusoid of pulse current having a peak magnitude significantly greater (*e.g.,* twice) the anticipated load current $I_L$ during the transfer interval of the load current. It may be noted that $C_{PULSE}$ and $L_{PULSE}$ may be selected so as to induce resonance in the pulse circuit **142.**

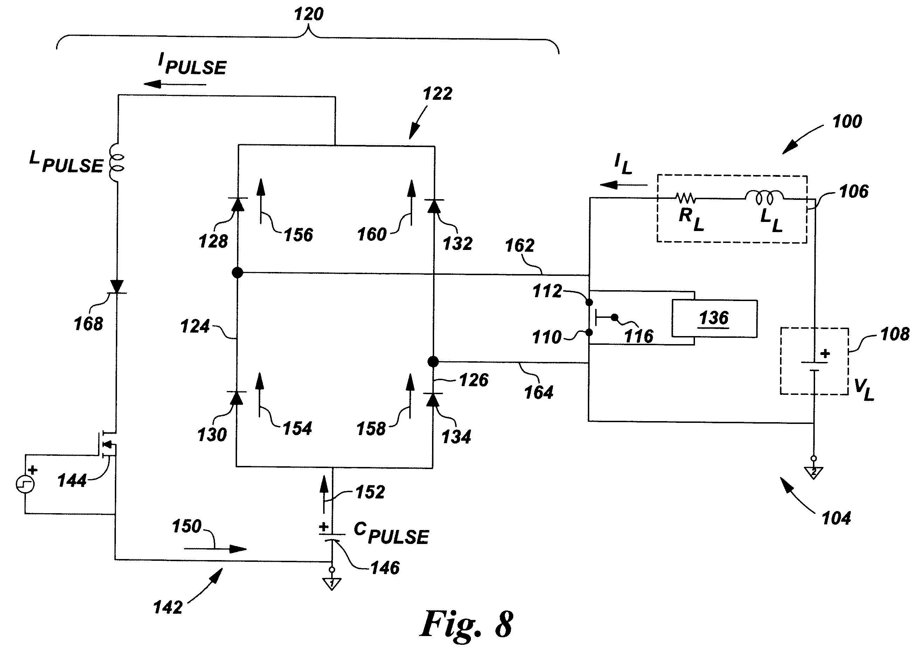

Fig. 8 schematically depicts a process of triggering the pulse circuit **142.** It may be noted that detection circuitry (not shown) may be coupled to the pulse circuit **142.** The detection circuitry may include sensing circuitry (not shown) configured to sense a level of the load circuit current $I_L$ and/or a value of the voltage level $V_L$, for example. Furthermore, the detection circuitry may be configured to detect a switch condition as described above. In one embodiment, the switch condition may occur due to the current level and/or the voltage level exceeding a predetermined threshold.

The pulse circuit **142** may be configured to detect the switch condition to facilitate switching the present fully-closed configuration of the switch **102** to an open configuration. In one embodiment, the switch condition may be a fault condition generated due to a voltage level or load current in the load circuit **104** exceeding a predetermined threshold level. However, as will be appreciated, the switch condition may also include monitoring a ramp voltage to achieve a given system-dependent ON time for the MEMS switch **102.**

In one embodiment, the pulse switch **144** may generate a sinusoidal pulse responsive to receiving a trigger signal as a result of a detected switching condition. The triggering of the pulse switch **144** may initiate a resonant sinusoidal pulse current $I_{PULSE}$ in the pulse circuit **142.** The current direction of the pulse current $I_{PULSE}$ may be represented by reference numerals **150** and **152.** Furthermore, the current direction and relative magnitude of the pulse current $I_{PULSE}$ through the first diode **128** and the second diode **130** of the first branch **124** of the balanced diode bridge **122** may be represented by current vectors **154** and **156,** respectively. Similarly, current vectors **158** and **160** are representative of a current direction and relative magnitude of the pulse circuit current through the third diode **132** and the fourth diode **134,** respectively.

The value of the peak sinusoidal bridge pulse current may be determined by the initial voltage on the pulse capacitor **146,** the value $C_{PULSE}$ of the pulse capacitor, and the inductance value $L_{PULSE}$ of the pulse circuit **142.** The values for $C_{PULSE}$ and $L_{PULSE}$ also determine the pulse width of the half sinusoid of pulse current $I_{PULSE}$. The bridge current pulse width may be adjusted to meet the system load current turn-off requirement predicated upon the rate of change of the load current $I_L$ and the desired peak let-through current during a load fault condition. The pulse switch **144** may be configured to be in a conducting state prior to opening the MEMS switch **102.**

It may be noted that triggering of the pulse switch **144** may include controlling a timing of the pulse current $I_{PULSE}$ through the balanced diode bridge **122** to facilitate creating a lower impedance path as compared to the impedance of a path through the contacts (*e.g.,* the beam **110** and the contact **112)** of the MEMS switch **102** during a switching event. In addition, the pulse switch **144** may be triggered such that a desired voltage drop is presented across the contacts of the MEMS switch **102**.

In one embodiment, the pulse switch **144** may be a solid-state switch that may be configured to have switching speeds in the range of nanoseconds to microseconds, for example. The switching speed of the pulse switch **144** should be relatively fast compared to the anticipated rise time of the load current in a fault condition. The current rating of the MEMS switch **102** is dependent on the rate of rise of the load current $I_L$, which in turn is dependent on the inductance $L_L$ and the supply voltage $V_L$ in the load circuit **104** as previously noted. The MEMS switch **102** may be appropriately rated to handle a larger load current $I_L$ if the load current $I_L$ may rise rapidly compared to the speed capability of the pulse circuit **142**.

The pulse current $I_{PULSE}$ can increase from a value of zero and divide equally between the first and second branches **124, 126** of the balanced diode bridge **122**. In accordance with one embodiment, the difference in voltage drops across the branches **124, 126** of the balanced diode bridge **122** may be designed to be negligible, as previously described. Further, as previously described, the diode bridge **122** can be balanced such that the voltage drop across the first and second branches **124, 126** of the diode bridge **122** are substantially equal. Moreover, as the resistance of the MEMS switch **102** in a present fully-closed state is relatively low, there is a relatively small voltage drop across the MEMS switch. However, if the voltage drop across the MEMS switch **102** happened to be larger *(e.g.,* due to an inherent design of the MEMS switch), the balancing of the diode bridge **122** may be affected as the diode bridge is operatively coupled in parallel with the MEMS switch. If the resistance of the MEMS switch **102** causes a significant voltage drop across the MEMS switch, then the diode bridge **122** may accommodate the resulting imbalance by increasing the magnitude of the peak bridge pulse current.

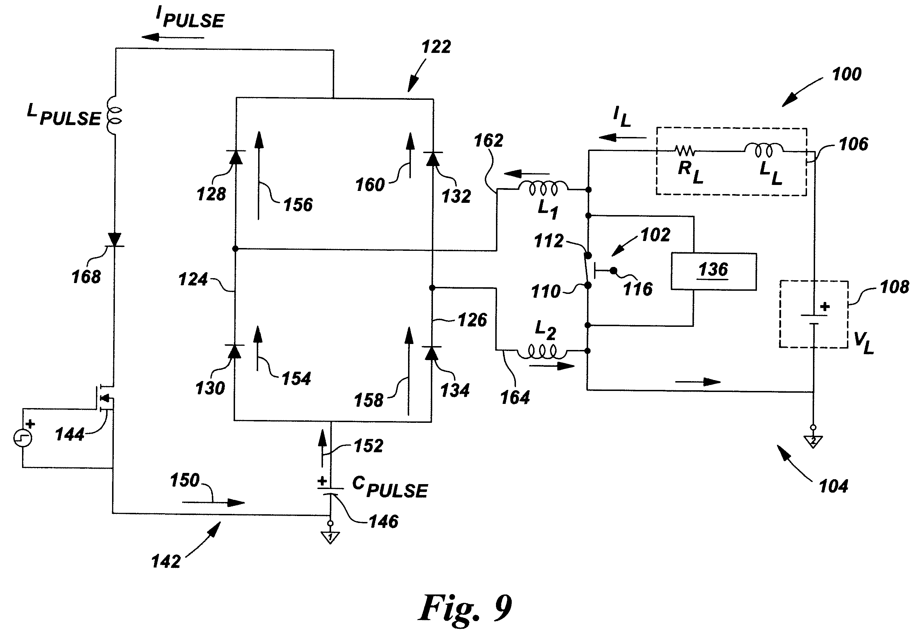

Referring now to Fig. 9, therein is a schematic depiction in which opening of the MEMS switch **102** is initiated. As previously noted, the pulse switch **144** in the pulse circuit **142** is triggered prior to opening the MEMS switch **102**. As the pulse current $I_{PULSE}$ increases, the voltage across the pulse capacitor **146** decreases due to the resonant action of the pulse circuit **142**. In the ON condition in which the MEMS switch **102** is fully-closed and conducting, the MEMS switch presents a path of relatively low impedance for the load circuit current $I_L$.

Once the amplitude of the pulse current $I_{PULSE}$ becomes greater than the amplitude of the load circuit current $I_L$ *(e.g.,* due to the resonant action of the pulse circuit **142**), a gate voltage can be applied to the MEMS switch **102** to switch the present operating state of the MEMS switch from the fully-closed and conducting state to an increasing resistance condition in which the MEMS switch starts to open and turn off *(e.g.,* where the beam **110** still contacts the contact **112** but contact pressure between the two is diminishing due the switch opening process). This causes the characteristic switch resistance to increase, which in turn causes the load current $I_L$ to start to divert from the MEMS switch **102** into the commutation circuit **120**.

In this present condition, the balanced diode bridge **122** presents a path of relatively low impedance to the load current $I_L$ as compared to a path through the MEMS switch **102,** which is now associated with an increasing characteristic resistance. It may be noted that this diversion of load current $I_L$ through the MEMS switch **102** is an extremely fast process compared to the rate of change of the load circuit current $I_L$. As previously noted, it may be desirable that the inductances $L_1$ and $L_2$ respectively associated with the connections **162, 164** between the MEMS switch **102** and the balanced diode bridge **122** are small in order to avoid inhibition of the fast current diversion.

As the process of current transfer from the MEMS switch **102** to the commutation circuit **120** continues, the current in each of the first diode **128** and the fourth diode **134** increases, while, simultaneously, the current in each of the second diode **130** and the third diode **132** is diminished. The transfer process is completed when the contacts *(e.g.,* the beam **110** and the contact **112)** of the MEMS switch **102** are separated to form a physical gap therebetween and all of the load current $I_L$ is carried by the first diode **128** and the fourth diode **134**.

Consequent to the load current $I_L$ being diverted from the MEMS switch **102** to the diode bridge **122** in direction **166,** an imbalance forms across the first and second branches **124, 126** of the diode bridge. Furthermore, as the pulse current $I_{PULSE}$ decays, voltage across the pulse capacitor **146** continues to reverse *(e.g.,* acting as a "back electromotive force")* which causes the eventual reduction of the load circuit current $I_L$ to zero. The second diode **130** and the third diode **132** in the diode bridge **122** may then become reverse biased, which results in load current $I_L$ being directed through the pulse circuit **142,** with the load current $I_L$ now interacting with the series resonant circuit characterized by the pulse inductance $L_{PULSE}$ and the capacitance $C_{PULSE}$ of the pulse capacitor **146**.

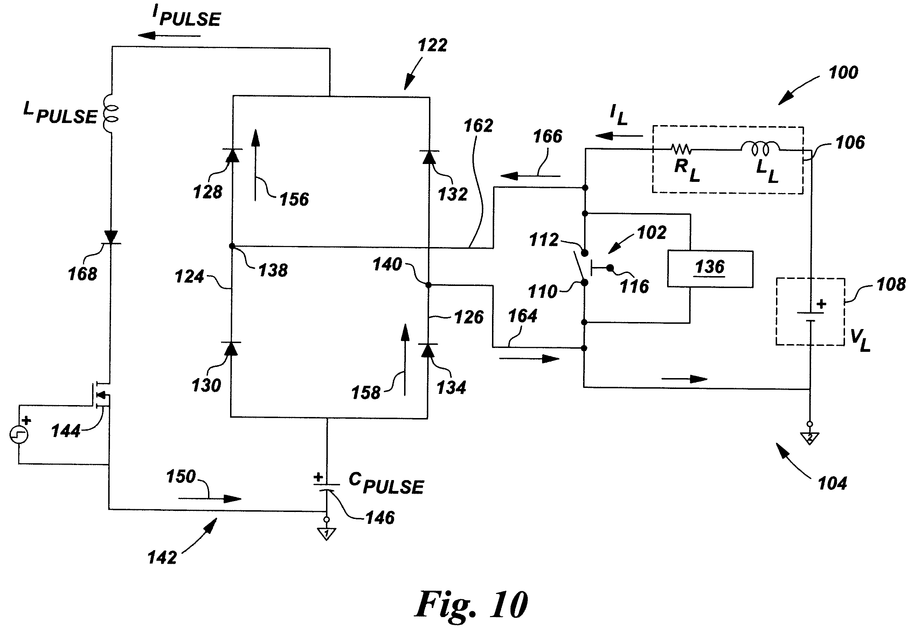

Turning now to Fig. 10, therein is a schematic depiction of the process of decreasing the load current $I_L$. At the instant that the contacts *(e.g.,* the beam **110** and the contact **112)** of the MEMS switch **102** part, infinite resistance is achieved. Furthermore, the diode bridge **122** no longer maintains a near-zero voltage across the contacts **110, 112** of the MEMS switch **102**. Also, the load circuit current $I_L$ is now equal to the current through the first diode **128** and the fourth diode **134**. As previously noted, there is now no current through the second diode **130** and the third diode **132**.

Additionally, a voltage difference from the contact **112** to the beam **110** of the MEMS switch **102** may now rise to a maximum of approximately twice the voltage $V_L$ at a rate determined by the net resonant circuit which includes the pulse inductance $L_{PULSE}$, the capacitance $C_{PULSE}$ of the pulse capacitor **146**, the load inductance $L_L$, and damping due to the load resistance $R_L$. Moreover, the pulse current $I_{PULSE}$, which is now equal to the load circuit current $I_L$, may resonantly decrease to a zero value and to maintain the zero value due to the reverse blocking action of the diode bridge **122** and the pulse circuit diode **168**. The voltage across the pulse capacitor **146** has at this point reversed resonantly to a negative peak, which negative peak value will be maintained until the pulse capacitor is recharged.

The diode bridge **122** may be configured to maintain a near-zero voltage across the contacts **110, 112** of the MEMS switch **102** until the contacts separate to open the MEMS switch, thereby preventing damage by suppressing any arc that would tend to form between the contacts of the MEMS switch during opening. Additionally, the contacts **110, 112** of the MEMS switch **102** approach the opened state at a much reduced current through the MEMS switch. Also, any stored energy in the load inductance $L_L$, (including inductances in the load circuit **104** and the power source **108)** may be transferred to the pulse capacitor **146** and may be absorbed via voltage dissipation circuitry (not shown). The voltage snubber circuit **136** may be configured to limit voltage overshoot during the fast contact separation due to inductive energy remaining in the interface between the bridge **122** and the MEMS switch **102**. Furthermore, the rate of increase of reapply voltage across the contacts **110, 112** of the MEMS switch **102** during opening may be controlled via use of the snubber circuit **136**.

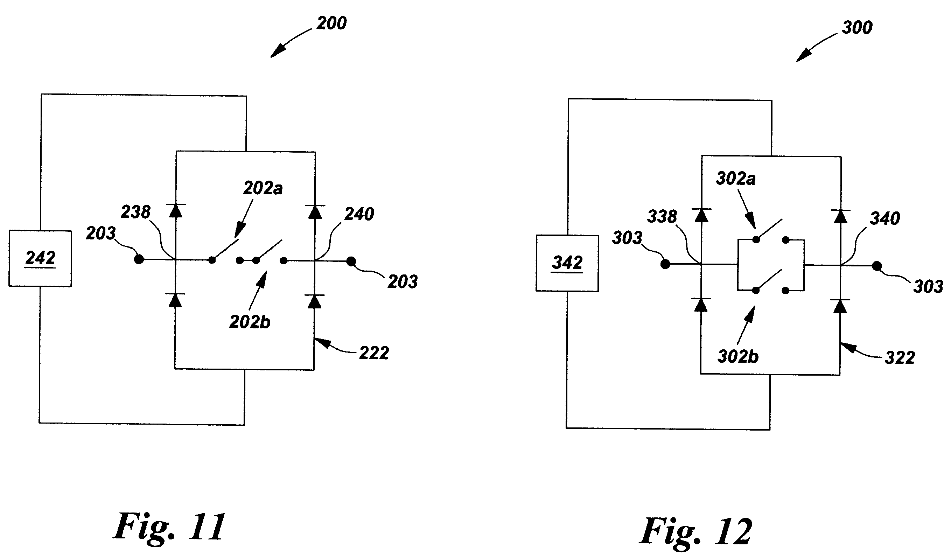

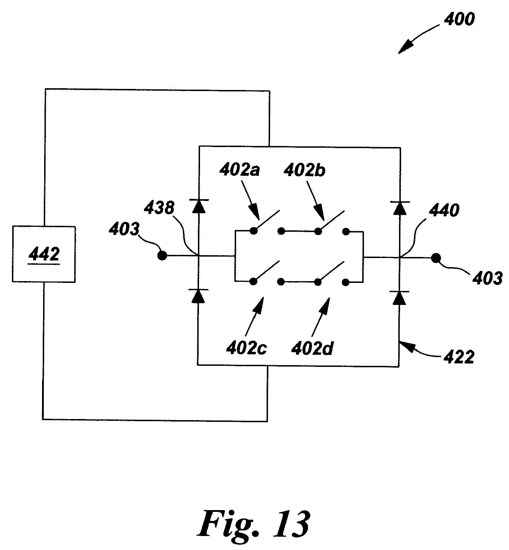

As mentioned above, embodiments of switch modules can employ electromechanical switches individually or as part of a switch array. For example, referring to Fig. 11, in one embodiment, a switch module **200** may include several electromechanical switches **202a, 202b** arranged as an array and connected in series between the midpoints **238, 240** of a balanced diode bridge **222**. A pulse circuit **242** can then be connected across the balanced diode bridge **222** as described above. Terminals **203** can be used to connect the switch module **200** to, say, a load circuit (not shown). Referring to Fig. 12, in another embodiment, a switch module **300** may include several electromechanical switches **302a, 302b** arranged as an array and connected in parallel between the midpoints **338, 340** of a balanced diode bridge **322**. Again, a pulse circuit **342** can be connected across the balanced diode bridge **322,** and terminals **303** can be used to connect the switch module **300** to a load circuit (not shown). Referring to Fig. 13, in yet another embodiment, a switch module **400** may include several electromechanical switches **402a, 402b, 402c, 402d** arranged as an array and connected both in series and in parallel between the midpoints **438, 440** of a balanced diode bridge **422**. Again, a pulse circuit **442** can be connected across the balanced diode bridge **422,** and terminals **403** can be used to connect the switch module **400** to a load circuit (not shown).

Referring again to Fig. 1, the commutation circuit **142** may be associated with a total inductance $L_{COM}$. The total commutation circuit inductance $L_{COM}$ may include, for example, the inductances $L_1$ and $L_2$ respectively associated with the connections **162, 164** between the MEMS switch **102** and the balanced diode bridge **122,** the pulse circuit inductance $L_{PULSE}$, and the inductance $L_B$ associated with the balanced diode bridge **122**. The MEMS switch **102** and the balanced diode bridge **122** can be disposed such that a total inductance $L_{COM}$ associated with the commutation circuit **142** is less than or equal to a product of the characteristic time for switch opening $T_C$ and the minimum characteristic switch resistance $R_{SMIN}$ (i.e., the switch resistance associated with a switch in the fully-closed configuration). As discussed below, configuring the switch module **100** in this way may help to avoid voltage surges across the switch **102**.

In order to maintain the total inductance $L_{COM}$ less than or equal to the product $R_{SMIN} \cdot T_C$, the minimum characteristic switch resistance $R_{SMIN}$ and/or the characteristic time $T_C$ over which the switch **102** is opened can be increased. However, increasing the minimum characteristic switch resistance $R_{SMIN}$ may lead to increased energy losses in the switch module **100**. Increasing the characteristic time $T_C$ over which the switch **102** is opened can result in more current being passed through the switch before opening, which may be unacceptable where the switch module is intended to divert fault current before it can reach a level sufficient to cause damage to a load. As such, in some embodiments, the switch **102** may be configured to move between open and fully-closed configurations over a characteristic time $T_C$ that is less than or equal to about 15 microseconds. For applications that allow for controlling the opening time for the switch **102,** it may be desirable in some embodiments to control the opening of the switch so as to generate a constant voltage during current commutation into the bridge **122,** at a voltage level that is just below what can be tolerated (i.e., $L_{COM} = R_{SMIN} \cdot T_C$). It is noted that a higher voltage may result in damage to the switch **102,** and a lower voltage may unnecessarily require more time.

With the above limitations in mind, it may be desirable to maintain the inductance $L_{COM}$ associated with the commutation circuit **142** at a level less than or equal to the product $R_{SMIN} \cdot T_C$ by physically disposing the components of the commutation circuit (e.g., the diode bridge **122,** the connections **162, 164,** and the pulse circuit **142**) so as to limit the area enclosed within the commutation circuit. For example, the MEMS switch **102** and the balanced diode bridge **122** may be packaged so as to be closely spaced to facilitate minimization of parasitic inductance caused by the balanced diode bridge and, in particular, the connections **162, 164** to the MEMS switch. In one embodiment, the MEMS switch **102** may be integrated with the balanced diode bridge **122,** for example, in a single package or the same die. The inherent inductance between the MEMS switch **102** and the balanced diode bridge **122** may in this way produce a di/dt voltage less than a few percent of the voltage across the contacts **110, 112** of the MEMS switch when carrying a transfer of the load current to the diode bridge during turn-off switching event.

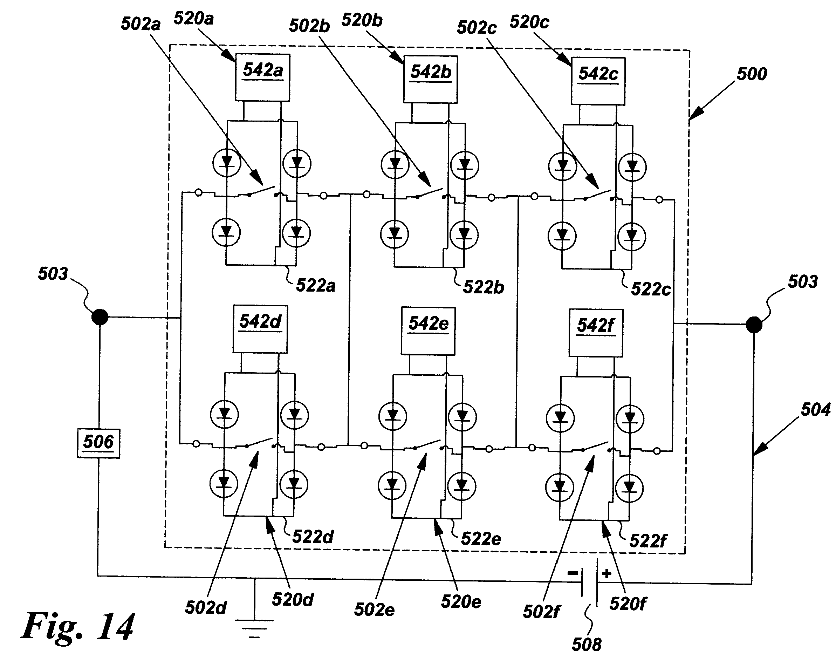

Referring to Fig. 14, therein is shown a switch module **500** configured in accordance with another example embodiment. The switch module **500** can include a first electromechanical switch structure **502a,** a second electromechanical switch structure **502b,** and third, fourth, fifth, and sixth electromechanical switch structures **502c, 502d, 502e, 502f,** each of which may include one or an array of switches connected together in series, parallel, or both. Each of the electromechanical switch structures **502a-f** can be configured to move between an open configuration and a fully-closed configuration (the latter being associated with a respective minimum characteristic switch resistance) over a respective characteristic time.

The electromechanical switch structures **502a-f** can be configured to connect to a load circuit **504** in parallel with one another (*e.g.*, see switch structures **502a** and **502d** in Fig. 14), in series with one another (*e.g.,* see switch structures **502a** and **502b** in Fig. 14), or both. For example, the electromechanical switch structures **502a-f** may be associated with terminals **503** that allow for the load circuit **504** to be connected across the switch structures. The load circuit **504** can include, for example, an electrical load **506** and a power source **508.**

Each electromechanical switch structure **502a-f** can be connected in parallel with a respective commutation circuit **520a-f.** Each of the commutation circuits **520a-f** can include a balanced diode bridge **522a-f** configured to suppress arc formation between contacts of a respective one of the electromechanical switch structures **502a-f.** Each of the commutation circuits **520a-f** can also include a respective pulse circuit **542a-f** configured to generate a pulse signal in connection with a switching event to cause pulse current to flow through the associated balanced diode bridge **522a-f.** Each electromechanical switch structure **502a-f** and associated balanced diode bridge **522a-f** can be respectively disposed relative to one another such that, for each combination of electromechanical switch structure **502a-f** and related commutation circuit **520a-f** (*e.g.*, switch **502a** and commutation circuit **520a** being one related combination, switch **502b** and commutation circuit **520b** being another related combination, etc.), a total inductance associated with the commutation circuit is less than or equal to a product of the characteristic time associated with the related switch and the minimum characteristic resistance of the related switch. In some embodiments, a voltage grading network (not shown) may also be included in the switch module **500.**

Each switch/bridge/pulse circuit combination may operate independently of the others, with each pulse circuit being sized according to the acceptable voltage and current levels for the switch being respectively protected. By placing the diode bridges **522a-f** (and associated diodes) as physically close as possible to the switches **502a-f,** the stray inductance of the commutation loop may be reduced. Further, by providing a dedicated commutation circuit **520a-f** for each electromechanical switch **502a-f** (or set of electromechanical switches in the case where the electromechanical switch structure includes an array of switches), each switch/switch array may be protected from potentially damaging voltage surges. If each combination of a switch/switch array and its associated commutation circuit is considered a discrete module element, the switch module **500** can then be constructed by assembling module elements in varying configurations, with each element being configured so as to conform to the design rule that the inductance of the commutation circuit is less than or equal to the product of the minimum switch resistance and the characteristic opening time of the switch.

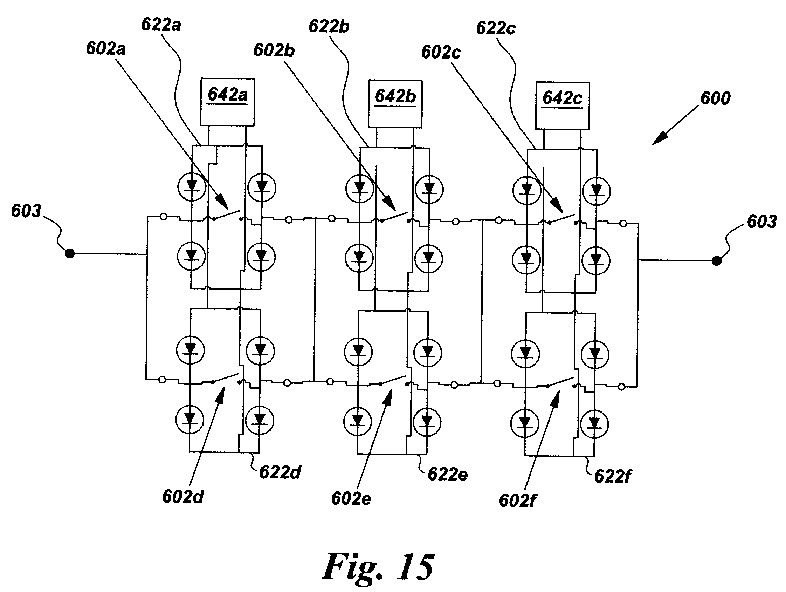

The switch module **500** includes a plurality of commutation circuits **520a-f.** In some embodiments, it may be desirable to reduce the overall complexity of the switch module, for example, by consolidating some of the commutation circuits. Specifically, referring to Fig. 15, therein is shown a switch module **600** configured in accordance with another example embodiment. The switch module **600** can include a plurality of electromechanical switches **602a-f** configured to connect, via terminals **603,** to a load circuit (not shown) in parallel with one another (*e.g.,* see switch structures **602a** and **602d** in Fig. 15) and in series with one another (*e.g.,* see switch structures **602a** and **602b** in Fig. 15).

Each electromechanical switch structure **602a-f** can be connected in parallel with a respective balanced diode bridge **622a-f.** Further, for switches configured to be connected in parallel to an external load circuit (*e.g.,* switch structures **602a** and **602d,** switch structures **602b** and **602e,** and switch structures **602c** and **602f** in Fig. 15), a respective pulse circuit **642a-c** can be configured to generate a pulse signal, in connection with a switching event, to cause pulse current to flow through the appropriate balanced diode bridge **622a-f** for the associated switches **602a-f.**

Each electromechanical switch structure **602a-f** and associated balanced diode bridge **622a-f** can be respectively disposed relative to one another such that, for each combination of electromechanical switch structure **602a-f** and related balanced diode bridge **622a-f** and pulse circuit **642a-c** (*e.g.*, switch **602a,** balanced diode bridge **622a,** and pulse circuit **642a** being one related combination; switch **602b,** balanced diode bridge **622b,** and pulse circuit **642b** being another related combination; switch **602d,** balanced diode bridge **622d,** and pulse circuit **642a** being yet another related combination, etc.), a total inductance associated with the pulse circuit/balanced diode bridge combination is less than or equal to a product of the characteristic time and the minimum characteristic resistance for the related switch.

Again, in some embodiments, it may be desirable to connect each diode bridge **622a-f** so as to be physically disposed as close as possible to the respectively associated switches **602a-f** in order to minimize the resulting stray inductance. Further, operation of a single pulse circuit **642a-c** applies a pulse of current to all of the diode bridges that are connected thereto (*e.g.*, in the embodiment depicted in Fig. 15, a pulse from pulse circuit **642a** supplies current to diode bridges **622a** and **622d).** The total pulse current is distributed approximately evenly amongst all of diode bridges connected thereto, and the current capacity of each diode bridge can be sized according to the load current to be carried by the associated switch. The voltage rating of each diode bridge **622a-f** and each pulse circuit **642a-c** can be determined by the voltage rating of a single switch.

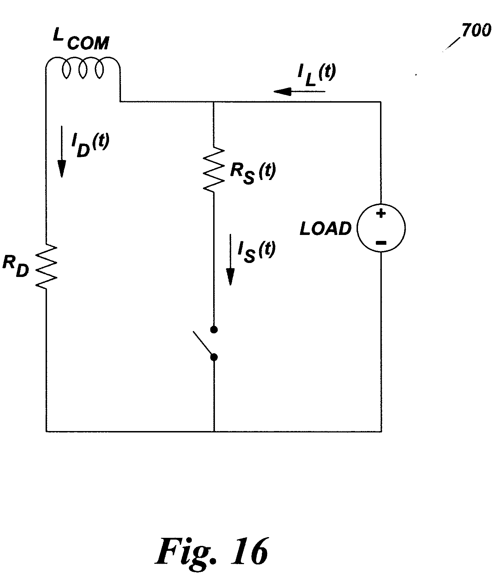

Referring to Fig. 1, overall, the balanced diode bridge **122** can afford switching protection for the associated MEMS switch **102** during switching events. By [configuring the switch **102** and the balanced diode bridge **122** such that a total inductance associated with the commutation circuit **142** is less than or equal to a product of the characteristic time and the minimum characteristic resistance for the switch, damaging voltage surges upon opening of the switch due to stray inductance may, in some embodiments, be mitigated. For example, referring to Fig. 16, therein is shown the applicable equivalent circuit **700** associated with the switch module **100** of Fig. 1, the equivalent circuit representing operation of the switch module during the time that the switch **102** (Fig. 1) is opening while being protected by the commutation circuit **142** (Fig. 1).

Referring to Figs. 1 and 16, $I_L(t)$ represents the load (or fault) current. During a load current pulse, $I_L(t)$ is determined entirely by the external circuit. $I_B(t)$ and $I_S(t)$ are portions of the load current that flow through the diode bridge **122** and through the switch **102**. When the transfer process starts, all of the current may be flowing through the switch **102**. The resistance $R_S(t)$ of the switch **102** may vary as a function of time, being initially at a minimum value $R_{SMIN}$ when the switch is in a fully-closed configuration and rising to infinity as the switch opens. $L_{COM}$ is the inductance of the commutation circuit **142** through which the current accomplishing the commutation flows, which current can be computed, for example, by analyzing the packaging and connections of the commutation circuit **142,** with shorted diodes **128, 130, 132, 134,** and computing the effective inductance as seen from the points of connection **162, 164.** $R_D$ is the equivalent resistance of the diode bridge **122** as seen from the MEMS switch **102** (in many cases, the equivalent resistance $R_D$ of the diode bridge is a nonlinear function of the currents flowing through the commutation circuit **142** and the load circuit **104,** but this resistance can be approximated well enough with a linear resistor).

The snubber circuit **136** is ignored for the purposes of the equivalent circuit **700**. While the switch **102** is opening, the voltage across the switch is limited to the melt voltage of the switch (on the order of 0.5 to 1.0 V). The snubber circuit **136** must therefore induce a change of voltage no greater than the melt voltage. This factor limits the allowable capacitance associated with the snubber circuit to around 20 nanofarads, and with a switch opening time around 8 microseconds, the current flowing through the snubber circuit **136** during a switching event of the switch **102** is expected to be less than 0.2 % of the total load current. Therefore, the snubber circuit **136** has practically no effect on the transient voltage across the switch **102** until after the switch is open, and the snubber circuit **136** can be ignored during the commutation process.

The transient behavior of the circuit in Fig. 16 is governed by a first order, time dependent differential equation:

$$L_D \cdot \frac{dI_D(t)}{dt} = R_S(t) \cdot \left( I_L(t) - I_D(t) \right) - R_D \cdot I_D(t) \tag{1}$$

$$I_D(0) = 0$$

Equation (1) can be rewritten as:

$$L_D \cdot \frac{dI_D(t)}{dt} + \left( R_D + R_S(t) \right) \cdot I_D(t) = R_S(t) \cdot I_L(t) \tag{2}$$

$$I_D(0) = 0$$

Equation (2) has a closed form solution, even with arbitrary functions of time for both the array switch resistance and the load current, given by:

$$I_D(t) = \frac{1}{L_{COM}} \cdot \int_0^t \left( e^{\frac{-1}{L_{COM}} \cdot \int_\tau^t (R_D + R_S(\lambda)) d\lambda} \right) \cdot R_S(\tau) \cdot I_L(\tau) \cdot d\tau \tag{3}$$

Assuming that the diode resistance $R_D$ is so small as to be negligible ($R_D = 0$), the load current is approximately constant during the switching event ($I_L(t) = I_L$), and the opening of the switch **102** is spread evenly over a characteristic time $T_C,$ such that the switch resistance $R_S(t)$ is given by:

$$R_S(t) = \frac{R_{SMIN}}{1 - t/T_C}, \, 0 \le t \le T_C \tag{4}$$

Direct substitution of (4) into (3) and simplification produces a simple expression for the diode current $I_D(t)$:

$$I_D(t) = I_L \cdot \left(1 - \left(1 - t/T_C\right)^{R_{SMIN} \cdot T_C / L_{COM}}\right) \tag{5}$$

Subtracting the diode current $I_D(t)$ in Equation (5) from the load current yields the switch current $I_S(t)$:

$$I_S(t) = I_L \cdot \left(1 - t/T_C\right)^{R_{SMIN} \cdot T_C / L_{COM}} \tag{6}$$

Equation (6) can be multiplied by the expression for the switch resistance $R_S(t)$ given by Equation (4) to determine the voltage $V_S(t)$ across the switch 102:

$$V_S(t) = I_L \cdot R_{SMIN} \cdot \left(1 - t/T_C\right)^{R_{SMIN} \cdot T_C / L_{COM} - 1} \tag{7}$$

From Equation (7), it can be seen that the behavior of the voltage $V_S(t)$ across the switch **102** depends on the sign of the exponent. If the exponent is positive ($L_{COM} < R_{SMIN} \cdot T_C$), the switch voltage $V_S(t)$ decays over; if the exponent is zero ($L_{COM} = R_{SMIN} \cdot T_C$), the voltage $V_S(t)$ is constant; and if the exponent is negative ($L_{COM} > R_{SMIN} \cdot T_C$), the voltage $V_S(t)$ rises over time (to a singularity). Physically, the value of $T_C = L_{COM}/R_{SMIN}$ marks the boundary between two different situations. For larger values of $T_C$, current is diverted to the diode bridge **122** faster than it is rejected by the opening switch **102**, so that the current through the switch decreases over the course of a switching event. However, for smaller values of $T_C$, the current cannot divert to the diode bridge **122** fast enough, and current through the switch **102** increases over time.

By disposing the switch **102** and the balanced diode bridge **122** such that the total inductance associated with said commutation circuit $L_{COM} \le R_{SMIN} \cdot T_C$, the voltage $V_S(t)$ across the switch **102** can, in some embodiments, be caused to remain constant or decay over the time associated with a switching event. In this way, way, damaging voltage surges when the switch **102** is opened may be mitigated in some embodiments.

While only certain features of the invention have been illustrated and described herein, many modifications and changes will occur to those skilled in the art. It is, therefore, to be understood that the appended claims are intended to cover all such modifications and changes as fall within the scope of the invention.

**Claims**

1. An apparatus comprising:

a gate voltage source (118), a microelectromechanical switch structure (102) including an electrode (116), the said electrode (116) being in electrical communication with the said gate voltage source (118), the said microelectromechanical switch structure (102) being configured to move between an open configuration and a fully-closed configuration over a characteristic time, the fully closed configuration being defined as maximum contact between the elements of the switch structure said microelectromechanical switch structure having a minimum characteristic resistance when in the fully-closed configuration; and
a commutation circuit (120) connected in parallel with said electromechanical switch structure and including a balanced diode bridge (122) configured to suppress arc formation between contacts of said electromechanical switch structure; and
a pulse circuit (142) including a pulse capacitor (146) configured to form a pulse signal for causing flow of a pulse current through said balanced diode bridge, the pulse signal being generated in connection with a switching event of said electromechanical switch structure,
wherein said electromechanical switch structure and said balanced diode bridge are physically disposed such that a total inductance associated with said commutation circuit is less than or equal to a product of the characteristic time and the minimum characteristic resistance.

2. The apparatus of Claim 1, further comprising a second electromechanical switch structure configured to move between an open configuration and a fully-closed configuration over a second characteristic time, said second electromechanical switch structure having a second minimum characteristic resistance when in the fully closed configuration, wherein said electromechanical switch structure is a first electromechanical switch structure that is configured to move between an open configuration and a fully-closed configuration over a first characteristic time and to have a first minimum characteristic resistance when in the fully closed configuration, and wherein said first and second electromechanical switch structures are configured to connect in parallel to a load circuit, and wherein said commutation circuit is connected in parallel with each of said first and second electromechanical switch structures, and wherein said balanced diode bridge is a first balanced diode bridge configured to suppress arc formation between contacts of said first electromechanical switch structure, and wherein said commutation circuit further includes a second balanced diode bridge configured to suppress arc formation between contacts of said second electromechanical switch structure, and wherein said pulse circuit includes a pulse capacitor configured to form a pulse signal for causing flow of a pulse current through each of said first and second balanced diode bridges, the pulse signal being generated in connection with a switching event of said first and second electromechanical switch structures, and wherein said first and second electromechanical switch structures and said first and second balanced diode bridges are disposed such that a total inductance associated with said pulse circuit and said first balanced diode bridge is less than or equal to a product of the first characteristic time and the first minimum characteristic resistance and a total inductance associated with said pulse circuit and said second balanced diode bridge is less than or equal to a product of the second characteristic time and the second minimum characteristic resistance.

3. The apparatus of Claim 1 or Claim 2, wherein said microelectromechanical switch structure includes a microelectromechanical switch.

4. The apparatus of any preceding Claim, wherein said microelectromechanical switch structure includes one or more contacts (112) and one or more moveable elements (110), each of said one or more moveable elements being in maximum contact with at least one of said one or more contacts when said electromechanical switch structure is disposed in the fully-closed configuration and each of said one or more moveable elements being separated from said one or more contacts when said electromechanical switch structure is disposed in the open configuration.

5. The apparatus of any preceding Claim, wherein said microelectromechanical switch structure includes a moveable element (110), a contact (112), and an electrode (116) configured to selectively receive a charge so as to establish a potential difference with said moveable element and thereby urge said moveable element over the characteristic time between a maximum contacting position, in which said moveable element makes maximum contact with said contact, and a non-contacting position, in which said moveable element is separated from said contact.

6. The apparatus of any preceding Claim, wherein said microelectromechanical switch structure is configured to move between an open configuration and a fully-closed configuration over a characteristic time that is less than or equal to about 15 microseconds.

7. The apparatus of any preceding Claim, wherein said microelectromechanical switch structure includes an array of electromechanical switches having a minimum characteristic effective array resistance when in the fully-closed configuration.

8. The apparatus of Claim 7, wherein said array of electromechanical switches includes at least two electromechanical switches connected in parallel.

9. The apparatus of Claim 7, wherein said array of electromechanical switches includes at least two electromechanical switches connected in series.

10. The apparatus of Claim 7, wherein said array of electromechanical switches includes at least two electromechanical switches connected in parallel and at least two electromechanical switches connected in series.

11. A method comprising:

   providing an apparatus as claimed in claim 1
   applying an electrostatic force to move the electromechanical switch structure into the fully-closed configuration;

and

varying the electrostatic force so as to move the electromechanical switch structure over a characteristic time from the fully-closed configuration to the open configuration, wherein the characteristic time is greater than a total inductance associated with said commutation circuit divided by the minimum characteristic resistance.

**Patentansprüche**

1. Vorrichtung, umfassend:

eine Gatespannungsquelle (118), eine mikroelektromechanische Schaltstruktur (102), die eine Elektrode (116) enthält, wobei die Elektrode (116) in elektrischer Kommunikation mit der Gatespannungsquelle (118) steht, wobei die mikroelektromechanische Schaltstruktur (102) so ausgelegt ist, dass sie sich zwischen einer offenen Konfiguration und einer vollständig geschlossenen Konfiguration über eine charakteristische Zeit bewegt, wobei die vollständig geschlossene Konfiguration als maximaler Kontakt zwischen den Elementen der Schaltstruktur definiert ist, wobei die mikroelektromechanische Schaltstruktur einen minimalen charakteristischen Widerstand hat, wenn sie sich in der vollständig geschlossenen Konfiguration befindet; und
eine Kommutierungsschaltung (120), die parallel zur elektromechanischen Schaltstruktur angeschlossen ist und Folgendes enthält:

eine abgeglichene Diodenbrücke (122), die zum Unterdrücken der Lichtbogenbildung zwischen Kontakten der elektromechanischen Schaltstruktur ausgelegt ist; und
eine Impulsschaltung (142), einschließlich eines Impulskondensators (146), der zum Bilden eines Impulssignals ausgelegt ist, um den Fluss eines Impulsstroms durch die abgeglichene Diodenbrücke zu bewirken, wobei das Impulssignal in Verbindung mit einem Schaltereignis der elektromechanischen Schaltstruktur erzeugt wird,
wobei die elektromechanische Schaltstruktur und die abgeglichene Diodenbrücke physisch derart angeordnet sind, dass eine Gesamtinduktanz, die mit der Kommutierungsschaltung verbunden ist, kleiner oder gleich einem Produkt aus der charakteristischen Zeit und dem minimalen charakteristischen Widerstand ist.

2. Vorrichtung nach Anspruch 1, die ferner eine zweite elektromechanische Schaltstruktur umfasst, welche dafür ausgelegt ist, sich zwischen einer offenen Konfiguration und einer vollständig geschlossenen Konfiguration über eine zweite charakteristische Zeit zu bewegen, wobei die zweite elektromechanische Schaltstruktur einen zweiten minimalen charakteristischen Widerstand hat, wenn sie in der vollständig geschlossenen Konfiguration ist, wobei die elektromechanische Schaltstruktur eine erste elektromechanische Schaltstruktur ist, die dafür ausgelegt ist, sich zwischen einer offenen Konfiguration und einer vollständig geschlossenen Konfiguration über eine erste charakteristische Zeit zu bewegen und einen ersten minimalen charakteristischen Widerstand zu haben, wenn sie in der vollständig geschlossenen Konfiguration ist, und wobei die erste und zweite elektromechanische Schaltstruktur dafür ausgelegt sind, parallel zu einer Lastschaltung angeschlossen zu werden, und wobei die Kommutierungsschaltung parallel zur ersten und zweiten elektromechanischen Schaltstruktur angeschlossen ist und wobei die abgeglichene Diodenbrücke eine erste abgeglichene Diodenbrücke ist, die dafür ausgelegt ist, die Lichtbogenbildung zwischen Kontakten der ersten elektromechanischen Schaltstruktur zu unterdrücken, und wobei die Kommutierungsschaltung ferner eine zweite abgeglichene Diodenbrücke enthält, die dafür ausgelegt ist, die Lichtbogenbildung zwischen Kontakten der zweiten elektromechanischen Schaltstruktur zu unterdrücken, und wobei die Impulsschaltung einen Impulskondensator enthält, der zum Bilden eines Impulssignals ausgelegt ist, mit dem der Fluss eines Impulsstroms durch jede der ersten und zweiten abgeglichenen Diodenbrücke bewirkt wird, wobei das Impulssignal in Verbindung mit einem Schaltereignis der ersten und zweiten elektromechanischen Schaltstruktur erzeugt wird und wobei die erste und zweite elektromechanische Schaltstruktur und die erste und zweite abgeglichene Diodenbrücke derart angeordnet sind, dass eine Gesamtinduktanz, die der Impulsschaltung und der ersten abgeglichenen Diodenbrücke verbunden ist, kleiner oder gleich einem Produkt aus der ersten charakteristischen Zeit und dem ersten minimalen charakteristischen Widerstand ist, und eine Gesamtinduktanz, die mit der Impulsschaltung und der zweiten abgeglichenen Diodenbrücke verbunden ist, kleiner oder gleich einem Produkt aus der zweiten charakteristischen Zeit und dem zweiten minimalen charakteristischen Widerstand ist.

3. Vorrichtung nach Anspruch 1 oder 2, wobei die mikroelektromechanische Schaltstruktur einen mikroelektromechanischen Schalter enthält.

4. Vorrichtung nach einem der vorherigen Ansprüche, wobei die mikroelektromechanische Schaltstruktur einen oder mehrere Kontakte (112) und ein oder mehrere bewegliche Elemente (110) enthält, wobei jedes des einen oder der mehreren Elemente in maximalem Kontakt mit mindestens einem aus dem einen oder den mehreren Kontakten ist, wenn die elektromechanische Schaltstruktur in der vollständig geschlossenen Konfiguration ist, und jedes des einen oder der mehreren beweglichen Elemente von dem einem oder den mehreren Kontakten getrennt ist, wenn die elektromechanische Schaltstruktur in der offenen Konfiguration angeordnet ist.

5. Vorrichtung nach einem der vorherigen Ansprüche, wobei die mikroelektromechanische Schaltstruktur ein bewegliches Element (110), einen Kontakt (112) und eine Elektrode (116) enthält, die zum selektiven Aufnehmen einer Ladung ausgelegt sind, um so eine Potenzialdifferenz mit dem beweglichen Element aufzubauen und damit das bewegliche Element über die charakteristische Zeit zwischen einer maximalen Kontaktzeit, in der das bewegliche Element maximalen Kontakt mit dem Kontakt herstellt, und einer kontaktlosen Position anzutreiben, in der das bewegliche Element vom Kontakt getrennt ist.

6. Vorrichtung nach einem der vorherigen Ansprüche, wobei die mikroelektromechanische Schaltstruktur dafür ausgelegt ist, sich zwischen einer offenen Konfiguration und einer vollständig geschlossenen Konfiguration über eine charakteristische Zeit zu bewegen, die kleiner oder gleich etwa 15 Mikrosekunden ist.

7. Vorrichtung nach einem der vorherigen Ansprüche, wobei die mikroelektromechanische Schaltstruktur ein Feld von elektromechanischen Schaltern enthält, die einen minimalen charakteristischen effektiven Feldwiderstand haben, wenn sie in der vollständig geschlossenen Konfiguration sind.

8. Vorrichtung nach Anspruch 7, wobei das Feld von elektromechanischen Schaltern mindestens zwei elektromechanische Schalter enthält, die parallel angeschlossen sind.

9. Vorrichtung nach Anspruch 7, wobei das Feld von elektromechanischen Schaltern mindestens zwei elektromechanische Schalter enthält, die in Reihe angeschlossen sind.

10. Vorrichtung nach Anspruch 7, wobei das Feld von elektromechanischen Schaltern mindestens zwei elektromechanische Schalter enthält, die parallel angeschlossen sind, und mindestens zwei elektromechanische Schalter, die in Reihe angeschlossen sind.

11. Verfahren, umfassend:

Bereitstellen einer Vorrichtung nach Anspruch 1, Anwenden einer elektrostatischen Kraft, um die elektromechanische Schaltstruktur in die vollständig geschlossene Konfiguration zu bewegen; und
Variieren der elektrostatischen Kraft, um so die elektromechanische Schaltstruktur über eine charakteristische Zeit von der vollständig geschlossenen Konfiguration in die offene Konfiguration zu bewegen, wobei die charakteristische Zeit größer als eine Gesamtinduktanz ist, die mit der Kommutierungsschaltung verbunden ist, dividiert durch den minimalen charakteristischen Widerstand.

**Revendications**

1. Appareil comprenant :

une source de tension de gâchette (118), une structure de commutation micro-électromécanique (102) comprenant une électrode (116), ladite électrode (116) étant en communication électrique avec ladite source de tension de gâchette (118), ladite structure de commutation micro-électromécanique (102) étant configurée pour se déplacer entre une configuration ouverte et une configuration complètement fermée sur une période de temps caractéristique, la configuration complètement fermée étant définie comme un contact maximal entre les éléments de la structure de commutation, ladite structure de commutation micro-électromécanique ayant une résistance caractéristique minimale lorsqu'elle se trouve dans la configuration complètement fermée ; et
un circuit de commutation (120) connecté en parallèle à ladite structure de commutation électromécanique et comprenant :
un pont de diodes équilibré (122) configuré pour supprimer la formation d'un arc entre les contacts de ladite structure de commutation électromécanique ; et
un circuit d'impulsion (142) comprenant une capacité d'impulsion (146) configuré pour former un signal d'impulsion afin de provoquer un flux de courant pulsé à travers ledit pont de diodes équilibré, le signal pulsé étant généré en liaison avec un événement de commutation de ladite structure de commutation électromécanique, dans lequel ladite structure de commutation électromécanique et ledit pont de diodes équilibré sont physiquement disposés de sorte que l'inductance totale associée audit circuit de commutation soit inférieure ou égale au produit de la période de temps caractéristique et de la résistance caractéristique minimale.

2. Appareil selon la revendication 1, comprenant en outre une seconde structure de commutation électromécanique configurée pour se déplacer entre une configuration ouverte et une configuration complètement fermée sur une seconde période de temps caractéristique, ladite seconde structure de commutation électromécanique ayant une seconde résistance caractéristique minimale lorsqu'elle se trouve dans la configuration complètement fermée, dans lequel ladite structure de commutation électromécanique est une première structure de commutation électromécanique qui est configurée pour se déplacer entre une configuration ouverte et une configuration complètement fermée sur une première période de temps caractéristique et pour avoir une première résistance caractéristique minimale lorsqu'elle se trouve dans la configuration complètement fermée, dans lequel lesdites première et seconde structures de commutation électromécaniques sont configurées pour se connecter en parallèle à un circuit de charge, dans lequel ledit circuit de commutation est connecté en parallèle à chacune desdites première et seconde structures de commutation électromécaniques, dans lequel ledit pont de diodes équilibré est un premier pont de diodes équilibré configuré pour supprimer la formation d'un arc entre les contacts de ladite première structure de commutation électromécanique, dans lequel ledit circuit de commutation comprend en outre un second pont de diodes équilibré configuré pour supprimer la formation d'un arc entre les contacts de ladite seconde structure de commutation électromécanique, dans lequel ledit circuit d'impulsion comprend un condensateur d'impulsion configuré pour former un signal d'impulsion afin de provoquer l'écoulement d'un courant pulsé à travers chacun desdits premier et second ponts de diodes équilibrés, le signal d'impulsion étant généré en liaison avec un événement de commutation desdites première et seconde de commutation électromécaniques, et dans lequel lesdites première et seconde structures de commutation électromécaniques et lesdits premier et second ponts de diodes équilibrés sont disposés de sorte que l'inductance totale associée audit circuit d'impulsion et audit premier pont de diodes équilibré soit inférieure ou égale au produit de la première période de temps caractéristique et de la première résistance caractéristique minimale et que l'inductance totale associée audit circuit d'impulsion et audit second pont de diodes équilibré soit inférieure ou égale au produit de la seconde période de temps caractéristique et de la seconde résistance caractéristique minimale.

3. Appareil selon la revendication 1 ou la revendication 2, dans lequel ladite structure de commutation micro-électromécanique comprend un commutateur micro-électromécanique.

4. Appareil selon l'une quelconque des revendications précédentes, dans lequel ladite structure de commutation micro- électromécanique comprend un ou plusieurs contacts (112) et un ou plusieurs éléments mobiles (110), chacun desdits un ou plusieurs éléments mobiles étant en contact maximal avec au moins l'un desdits un ou plusieurs contacts lorsque ladite structure de commutation électromécanique est disposée dans la configuration complètement fermée et chacun desdits un ou plusieurs éléments mobiles étant séparé desdits un ou plusieurs contacts lorsque ladite structure de commutation électromécanique est disposée en configuration ouverte.

5. Appareil selon l'une quelconque des revendications précédentes, dans lequel ladite structure de commutation micro- électromécanique comprend un élément mobile (110), un contact (112) et une électrode (116) configurée pour recevoir sélectivement une charge de manière à établir une différence de potentiel avec ledit élément mobile et presser de la sorte ledit élément mobile sur la période de temps caractéristique entre une position de contact maximale, dans laquelle ledit élément mobile établit un contact maximal avec ledit contact, et une position hors contact, dans laquelle ledit élément mobile est séparé dudit contact.

6. Appareil selon l'une quelconque des revendications précédentes, dans lequel ladite structure de commutation micro- électromécanique est configurée pour se déplacer entre une configuration ouverte et une configuration complètement fermée sur une période de temps caractéristique qui est inférieure ou égale à environ 15 microsecondes.

7. Appareil selon l'une quelconque des revendications précédentes, dans lequel ladite structure de commutation micro- électromécanique comprend un réseau de commutateurs électromécaniques ayant une résistance de réseau efficace caractéristique minimale lorsqu'elle se trouve dans la configuration complètement fermée.

8. Appareil selon la revendication 7, dans lequel ledit réseau de commutateurs électromécaniques comprend au moins deux commutateurs électromécaniques connectés en parallèle.

**9.** Appareil selon la revendication 7, dans lequel ledit réseau de commutateurs électromécaniques comprend au moins deux commutateurs électromécaniques connectés en série.

**10.** Appareil selon la revendication 7, dans ledit réseau de commutateurs électromécaniques comprend au moins deux commutateurs électromécaniques connectés en parallèle et au moins deux commutateurs électromécaniques connectés en série.

**11.** Procédé comprenant les étapes consistant à :

fournir un appareil selon la revendication 1,
appliquer une force électrostatique pour déplacer la structure de commutation électromécanique en configuration complètement fermée ; et
faire varier la force électrostatique de manière à déplacer la structure de commutation électromécanique sur une période de temps caractéristique de la configuration complètement fermée à la configuration ouverte, dans lequel la période de temps caractéristique est supérieure à une inductance totale associée audit circuit de commutation divisée par la résistance caractéristique minimale.

*Fig. 1*

**Fig. 2**

$t = t_0$

**Fig. 3**

18

EP 2 337 043 B1

*Fig. 5*

*Fig. 4*

*Fig. 6*

EP 2 337 043 B1

*Fig. 7*

*Fig. 8*

EP 2 337 043 B1

*Fig. 9*

*Fig. 10*

Fig. 12

Fig. 11

*Fig. 13*

*Fig. 14*

EP 2 337 043 B1

Fig. 15

*Fig. 16*

EP 2 337 043 B1

**EP 2 337 043 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2045823 A